# FASCICULE DE BREVET EUROPEEN

(11) **EP 3 156 809 B1**
(45) Date de publication et mention de la délivrance du brevet: **28.04.2021**
(21) Numéro de dépôt: 16192087.1
(22) Date de dépôt: 03.10.2016
(51) Int. Cl.: G01R 22/06, H01H 71/04, H01H 9/56, H01H 1/00

(54) **COMPTEUR ÉLECTRIQUE ET PROCÉDÉ DE COMMANDE D'UNE OUVERTURE ET D'UNE FERMETURE D'UN ORGANE DE COUPURE DU COMPTEUR ÉLECTRIQUE**
STROMZÄHLER UND STEUERVERFAHREN DES ÖFFNUNGS- UND SCHLIESSVORGANGS EINES TRENNORGANS DES STROMZÄHLERS
ELECTRICITY METER AND METHOD FOR CONTROLLING AN OPENING AND A CLOSING OF AN INTERRUPTING MEMBER OF THE ELECTRICITY METER

(30) Priorité: 16.10.2015 FR 1559919
(43) Date de publication de la demande: 19.04.2017
(73) Titulaire: SAGEMCOM ENERGY & TELECOM SAS, 92500 Rueil-Malmaison (FR)
(72) Inventeur: TEBOULLE, Henri, 92500 RUEIL MALMAISON (FR); GRINCOURT, Christophe, 92500 RUEIL MALMAISON (FR)
(74) Mandataire: Lavaud, Thomas

(56) Documents cités:
- EP-A1- 2 503 343
- FR-A1- 2 953 938
- US-A- 5 273 151

## Description

L'invention concerne le domaine des compteurs d'énergie électrique.

### ARRIERE PLAN DE L'INVENTION

Les compteurs d'énergie électrique modernes sont des compteurs électroniques dits « intelligents » qui sont bien sûr adaptés à mesurer une quantité d'énergie électrique fournie par un distributeur à une installation électrique via un réseau de distribution, mais qui sont aussi capables de réaliser un certain nombre de fonctions complémentaires : gestion des tarifs par réception d'ordres, relève et programmation à distance, télé-information client, etc.

Ces compteurs comportent parfois un organe de coupure monté sur un conducteur de phase et permettant de sélectivement connecter et déconnecter, à distance, l'installation électrique du réseau de distribution.

L'organe de coupure est notamment utilisé pour protéger l'installation électrique en s'ouvrant lorsqu'il est soumis à une surtension accidentelle provenant du réseau de distribution, et en se refermant suite à cette surtension accidentelle sur commande d'un opérateur du distributeur. L'organe de coupure est aussi utilisé pour couper ou rétablir à distance l'alimentation de l'installation électrique en cas, par exemple, de résiliation de l'abonnement de l'utilisateur de l'installation électrique ou de non-paiement de l'énergie électrique consommée, sans qu'il soit nécessaire d'envoyer du personnel sur place.

Il est préférable d'ouvrir l'organe de coupure lorsque le courant électrique alternatif qui le traverse s'annule, de manière à limiter la formation d'arcs électriques qui fragilisent l'organe de coupure et réduisent sa durée de vie, et qui dégradent les équipements de l'installation électrique. Comme le courant électrique alternatif est un signal sensiblement sinusoïdal, l'amplitude (en valeur absolue) du courant électrique alternatif augmente rapidement après s'être annulée, et une mauvaise estimation de l'instant où le courant électrique alternatif s'annule conduit à ouvrir l'organe de coupure alors que ledit courant électrique alternatif présente une amplitude importante.

Il est, pour les mêmes raisons, préférable de fermer l'organe de coupure lorsque la tension électrique alternative à ses bornes s'annule.

Pour ouvrir l'organe de coupure à l'instant précis où le courant électrique alternatif traversant l'organe de coupure s'annule et fermer l'organe de coupure à l'instant précis où la tension électrique alternative aux bornes de l'organe de coupure s'annule, il a été envisagé d'utiliser directement une mesure du courant et une mesure de la tension. On temporise alors l'ouverture et la fermeture de l'organe de coupure pour que l'ouverture ait lieu au moment où le courant s'annule et pour que la fermeture ait lieu au moment où la tension s'annule.

Cette solution est complexe à mettre en œuvre du fait des signaux parasites qui perturbent les mesures de courant et de tension lors des commutations de l'organe de coupure

Un exemple de cette solution est décrit dans FR 2 953 938 A1.

Il a aussi été envisagé d'utiliser un dispositif de détection à barrière lumineuse pour détecter l'ouverture effective de l'organe de coupure et la fermeture effective de l'organe de coupure, et pour mesurer un délai d'ouverture entre la commande d'ouverture et l'ouverture effective et un délai de fermeture entre la commande de fermeture et la fermeture effective de l'organe de coupure. On anticipe alors la commande d'ouverture et la commande de fermeture de l'organe de coupure en tenant compte de ce délai.

Un tel dispositif nécessite de concevoir et d'utiliser un organe de coupure dédié à cette application, ce qui augmente nettement le coût total du compteur électrique.

### OBJET DE L'INVENTION

L'invention a pour objet d'ouvrir (respectivement de fermer) un organe de coupure d'un compteur électrique à un instant proche de l'instant où le courant qui le traverse s'annule (respectivement, à un instant proche de l'instant où la tension à ses bornes s'annule), sans augmenter de manière importante le coût du compteur électrique.

### RESUME DE L'INVENTION

En vue de la réalisation de ce but, on propose un compteur électrique comportant un organe de coupure, des moyens de commande de l'organe de coupure, et des moyens d'estimation d'un délai d'ouverture entre une commande d'ouverture et une ouverture effective de l'organe de coupure et/ou d'un délai de fermeture entre une commande de fermeture et une fermeture effective de l'organe de coupure, les moyens d'estimation comportant :
- un circuit inductif résonant comprenant une bobine montée fixe par rapport à l'organe de coupure en regard d'une trajectoire d'un contact mobile de l'organe de coupure ;
- des moyens d'émission agencés pour émettre dans le circuit inductif une impulsion de tension ;
- des moyens de détection agencés pour détecter un signal oscillatoire amorti de tension en sortie du circuit inductif et le comparer à une tension de référence, et pour détecter la position du contact mobile et donc l'ouverture effective ou la fermeture effective de l'organe de coupure en fonction du nombre d'oscillations supérieures à la tension de référence ;
- des moyens de mesure pour mesurer le temps entre la commande d'ouverture et la détection de l'ouverture effective pour estimer le délai d'ouverture et/ou entre la commande de fermeture et la détection de la fermeture effective pour estimer le délai de fermeture.

L'estimation du délai d'ouverture et du délai de fermeture grâce aux moyens d'estimation permet d'anticiper la commande d'ouverture et la commande de fermeture, de manière à assurer que l'ouverture effective et la fermeture effective de l'organe de coupure ont bien lieu respectivement lorsque le courant traversant l'organe de coupure s'annule et lorsque la tension aux bornes de l'organe de coupure s'annule.

L'utilisation du circuit inductif et de la bobine montée en regard de la trajectoire du contact mobile de l'organe de coupure permet par ailleurs d'associer les moyens d'estimation à un organe de coupure préexistant, sans qu'il soit nécessaire de concevoir un organe de coupure dédié à cette application. Le compteur électrique de l'invention peut donc être équipé d'un organe de coupure traditionnel, et donc l'intégration des moyens d'estimation ne s'accompagne pas d'un surcoût important.

L'invention sera mieux comprise à la lumière de la description qui suit d'un mode de mise en œuvre particulier non limitatif de l'invention.

### BREVE DESCRIPTION DES DESSINS

Il sera fait référence aux dessins annexés, parmi lesquels :
- la figure 1 représente un organe de coupure d'un compteur électrique de l'invention et des moyens d'estimation d'un délai d'ouverture et de fermeture de l'organe de coupure, l'organe de coupure étant fermé ;
- la figure 2 est une figure analogue à la figure 1, dans laquelle l'organe de coupure est ouvert ;
- la figure 3 représente un schéma électrique des moyens d'estimation du compteur électrique de l'invention ;
- la figure 4 représente un signal oscillatoire amorti produit par les moyens d'estimation alors que l'organe de coupure est fermé ;
- la figure 5 représente un signal oscillatoire amorti produit par les moyens d'estimation alors que l'organe de coupure est ouvert.

### DESCRIPTION DETAILLEE DE L'INVENTION

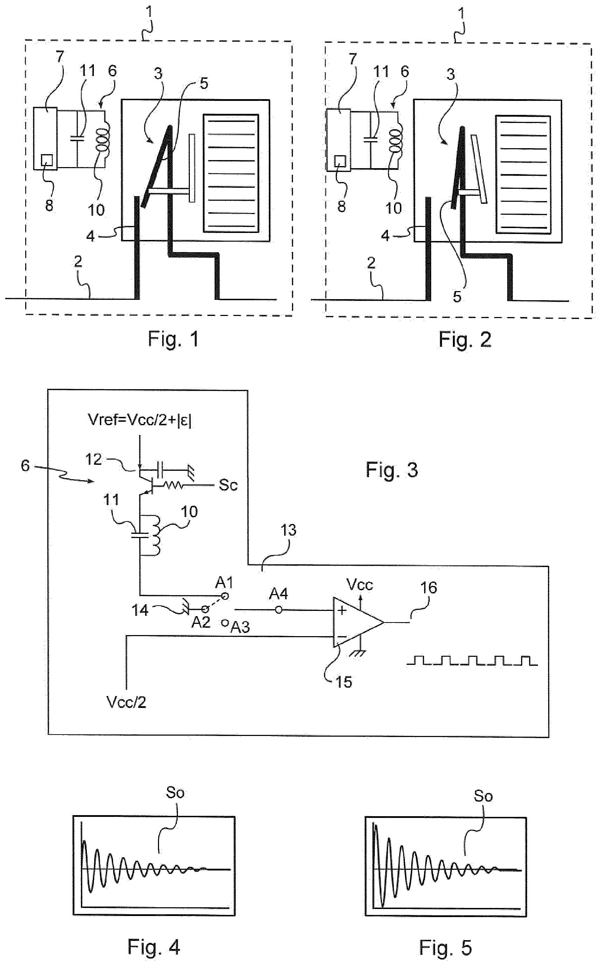

En référence aux figures 1 et 2, le compteur électrique de l'invention 1 est ici destiné à mesurer une énergie électrique qui est fournie par un réseau de distribution situé en amont du compteur 1 et qui est consommée par une installation électrique située en aval du compteur 1. L'énergie électrique est transmise à l'installation électrique par une ligne électrique comprenant un conducteur de phase 2 et un conducteur de neutre auxquels est raccordé le compteur 1.

Le compteur 1 comporte un organe de coupure 3 qui est monté sur le conducteur de phase 2 à l'intérieur du compteur 1. L'organe de coupure 3 permet de sélectivement connecter et déconnecter, à distance, l'installation électrique du réseau de distribution.

L'état fermé (visible sur la figure 1) et l'état ouvert (visible sur la figure 2) de l'organe de coupure 3 peuvent être commandés par le fournisseur d'énergie électrique (ou par le gestionnaire du réseau).

L'organe de coupure 3 comporte un contact fixe métallique 4 et un contact mobile métallique 5. La commande de l'état ouvert de l'organe de coupure 3 est réalisée en éloignant le contact mobile 5 du contact fixe 4, alors que la commande de l'état fermé est réalisée en mettant en contact le contact mobile 5 et le contact fixe 4.

Le compteur 1 comporte des moyens d'estimation d'un délai d'ouverture entre une commande d'ouverture et une ouverture effective de l'organe de coupure 3 et d'un délai de fermeture entre une commande de fermeture et une fermeture effective de l'organe de coupure 3.

Les moyens d'estimation sont tout d'abord adaptés à détecter l'ouverture effective et la fermeture effective de l'organe de coupure 3.

L'ouverture effective et la fermeture effective de l'organe de coupure 3 sont détectées par les moyens d'estimation en fonction de la position du contact mobile 5.

Pour détecter la position du contact mobile 5 et donc l'ouverture effective et la fermeture effective de l'organe de coupure 3, les moyens d'estimation comportent un circuit inductif résonant 6 relié à une unité de traitement 7 comportant un microcontrôleur 8.

Le circuit inductif 6 comprend une bobine 10 montée fixe par rapport à l'organe de coupure 3 et en regard d'une trajectoire du contact mobile 5, et un condensateur 11 monté en parallèle de la bobine 10.

Lorsque l'organe de coupure 3 est fermé, le contact mobile 5 est rapproché de la bobine 10. La présence du contact mobile 5 à proximité de la bobine 10 modifie de manière importante la valeur d'inductance équivalente aux bornes de la bobine 10.

En référence à la figure 3, la bobine 10 a une extrémité haute reliée à une source de tension Vref = Vcc/2 + |ε| (de manière à être légèrement supérieure à Vcc/2, qui correspond à la tension de référence de l'entrée négative du comparateur 15) par un transistor 12 commandé par le microcontrôleur 8. La bobine 10 a une extrémité basse reliée à une première borne A1 d'un commutateur 13 ayant une deuxième borne A2 reliée à la masse 14, une troisième borne A3 en haute impédance et une quatrième borne A4 reliée à l'entrée positive d'un comparateur 15 alimenté par Vcc. Le comparateur 15 a une entrée négative reliée à une tension de référence Vcc/2 et une sortie 16 reliée à une entrée du microcontrôleur 8 qui intègre un mécanisme permettant de compter les fronts montants (on pourrait également compter les fronts descendants au lieu des fronts montants) en sortie du comparateur 15, la forme d'onde du signal en sortie du comparateur étant un signal impulsionnel rectangulaire.

A titre indicatif, les composants utilisés sont typiquement une bobine 10 d'inductance 56µH, un condensateur 11 de capacité 2,2nF, une tension Vcc de 3,3V. Le signal impulsionnel rectangulaire est typiquement un signal à 3,3V.

Le microcontrôleur 8 pilote le transistor 12 entre un état passant et un état bloqué au moyen d'un signal de commande Sc.

L'unité de traitement 7 est agencée pour réaliser périodiquement, c'est-à-dire à des temps tn régulièrement espacés d'une durée ici égale à 100 microsecondes, une opération de détection en mettant en œuvre les étapes suivantes :
- émettre dans le circuit inductif 6, au temps tn et pendant une durée typiquement de 2 microsecondes, une impulsion de tension Vref en connectant l'extrémité basse de la bobine 10 à la masse 14 grâce au commutateur 13 et en connectant l'extrémité haute de la bobine 10 à la source de tension Vref grâce au transistor 12, puis en connectant, à l'issue des 2 microsecondes, l'extrémité basse de la bobine 10 à l'entrée positive du comparateur 15 grâce au commutateur 13 ;
- détecter un signal oscillatoire amorti de tension So en sortie du circuit inductif 6 et le comparer à la tension de référence Vcc/2 de manière à obtenir des impulsions rectangulaires lorsque les oscillations ont une amplitude supérieure à Vcc/2 ;
- compter au temps t = tn+t0 le nombre de fronts montants fournis par le circuit inductif 6 ;
- détecter la présence du contact mobile 5 lorsque le circuit inductif 6 livre un nombre de fronts montants M inférieur ou égal à un seuil Mseuil;
- détecter l'absence du contact mobile 5 lorsque le circuit inductif livre un nombre de fronts montants M supérieur au seuil Mseuil.

Le seuil Mseuil est typiquement fixé à 5.

On comprend que le circuit inductif 6 amortit l'impulsion de tension et fournit un signal oscillatoire amorti So. Le signal oscillatoire amorti So en présence du contact mobile 5 (visible sur la figure 4) présente un amortissement plus important que le signal oscillatoire amorti en l'absence du contact mobile 5 (visible sur la figure 5).

Ainsi, les moyens d'estimation détectent en temps réel et à intervalles réguliers (les intervalles réguliers sont ici égaux à 100 microsecondes) la position du contact mobile 5, et donc l'ouverture effective ou la fermeture effective de l'organe de coupure 3.

Les moyens d'estimation comportent en outre des moyens de mesure qui mesurent le temps entre la commande d'ouverture et la détection de l'ouverture effective pour estimer le délai d'ouverture, et entre la commande de fermeture et la détection de la fermeture effective pour estimer le délai de fermeture.

Ces moyens de mesure sont constitués par un programme implémenté dans le microcontrôleur 8 qui, pour chaque commande d'ouverture, acquiert l'instant auquel la commande d'ouverture est réalisée ainsi que l'instant auquel l'ouverture effective est détectée pour la première fois suite à la commande d'ouverture, et calcule la différence entre ces deux instants pour estimer le délai d'ouverture.

De même, pour chaque commande de fermeture, le programme acquiert l'instant auquel la commande de fermeture est réalisée ainsi que l'instant auquel la fermeture effective est détectée pour la première fois suite à la commande de fermeture, et calcule la différence entre ces deux instants pour estimer le délai de fermeture.

Comme la détection de l'ouverture effective et de la fermeture effective de l'organe de coupure 3 est ici réalisée toutes les 100 microsecondes, le délai d'ouverture et le délai de fermeture sont estimés avec une imprécision maximale de l'ordre de 100 microsecondes (on considère en effet que les instants auxquels la commande d'ouverture et la commande de fermeture sont réalisées sont estimés avec une imprécision presque nulle).

L'ouverture et la fermeture de l'organe de coupure 3 sont commandées en utilisant le délai d'ouverture et le délai de fermeture de l'organe de coupure 3 estimés par les moyens d'estimation, de manière à ouvrir l'organe de coupure 3 lorsque le courant électrique alternatif le traversant est nul (ou presque) et à fermer l'organe de coupure 3 lorsque la tension électrique alternative à ses bornes est nulle (ou presque).

Pour cela, à chaque commande d'ouverture de l'organe de coupure 3, les moyens d'estimation estiment le délai d'ouverture de l'organe de coupure 3.

La commande d'ouverture suivante est ensuite anticipée d'un temps égal au délai d'ouverture. La commande d'ouverture suivante est ainsi réalisée à un instant Ti0-to, Ti0 étant un instant proche du moment où il convient d'ouvrir l'organe de coupure 3 et où le courant électrique traversant l'organe de coupure 3 est supposé être nul, et to est le délai d'ouverture qui vient d'être estimé.

L'ouverture est donc commandée de sorte que l'ouverture effective de l'organe de coupure 3 ait lieu précisément (ici, à 100 microsecondes près maximum) au moment où le courant électrique s'annule. Le délai d'ouverture est estimé et mis à jour à chaque commande d'ouverture, de sorte que cette estimation demeure précise malgré les différentes variations environnementales (température, humidité) et structurelles (dues notamment au vieillissement) subies par l'organe de coupure 3.

De même, à chaque commande de fermeture de l'organe de coupure 3, les moyens d'estimation estiment le délai de fermeture de l'organe de coupure 3.

La commande de fermeture suivante est ensuite anticipée d'un temps égal au délai de fermeture. La commande de fermeture suivante est ainsi réalisée à un instant Tv0-tf, Tv0 étant un instant proche du moment où il convient d'ouvrir l'organe de coupure 3 et où la tension électrique aux bornes de l'organe de coupure 3 est supposée être nulle, et tf étant le délai de fermeture qui vient d'être estimé.

La fermeture est donc commandée de sorte que la fermeture effective de l'organe de coupure 3 ait lieu précisément (ici, à environ 100 microsecondes près) au moment où la tension électrique s'annule. Le délai de fermeture est estimé et mis à jour à chaque commande de fermeture.

On note que la mesure du courant électrique et la mesure de la tension électrique sont réalisées par des capteurs de courant et de tension présents dans le compteur 1, et que le moment où le courant électrique traversant l'organe de coupure 3 est supposé être nul et le moment où la tension électrique aux bornes l'organe de coupure 3 est supposée être nulle sont estimés respectivement grâce au capteur de courant et au capteur de tension.

On note aussi que le délai d'ouverture et le délai de fermeture sont initialisés et mémorisés au cours d'une étape de calibration ayant lieu lors de la fabrication du compteur. Au moment de la fabrication du compteur 1 (par exemple lors de son assemblage), on estime le délai d'ouverture et le délai de fermeture de la manière décrite plus tôt, et on mémorise ces délais dans une mémoire du compteur 1. Le délai d'ouverture et le délai de fermeture estimés lors de cette étape de calibration sont utilisés au moment de commander la première ouverture et la première fermeture de l'organe de coupure 3 du compteur 1 lorsque ce dernier est mis en service.

Bien entendu, l'invention n'est pas limitée au mode de réalisation décrit mais englobe toute variante entrant dans le champ de l'invention telle que définie par les revendications.

Le compteur électrique peut ainsi être un compteur polyphasé (par exemple triphasé) muni d'une pluralité d'organes de coupure à commandes indépendantes. Les principes de l'invention s'appliquent alors à chaque organe de coupure.

## Revendications

1. Compteur électrique comportant un organe de coupure (3), des moyens de commande de l'organe de coupure (3), et des moyens d'estimation d'un délai d'ouverture entre une commande d'ouverture et une ouverture effective de l'organe de coupure (3) et/ou d'un délai de fermeture entre une commande de fermeture et une fermeture effective de l'organe de coupure (3), les moyens d'estimation comportant :
- un circuit inductif (6) résonant comprenant une bobine (10) montée fixe par rapport à l'organe de coupure en regard d'une trajectoire d'un contact mobile (5) de l'organe de coupure ;
- des moyens d'émission agencés pour émettre dans le circuit inductif une impulsion de tension ;
- des moyens de détection agencés pour détecter un signal oscillatoire amorti de tension (So) en sortie du circuit inductif et le comparer à une tension de référence, et pour détecter la position du contact mobile (5) et donc l'ouverture effective ou la fermeture effective de l'organe de coupure en fonction du nombre d'oscillations supérieures à la tension de référence ;
- des moyens de mesure pour mesurer le temps entre la commande d'ouverture et la détection de l'ouverture effective pour estimer le délai d'ouverture et/ou entre la commande de fermeture et la détection de la fermeture effective pour estimer le délai de fermeture.

2. Compteur électrique selon la revendication 1, dans lequel l'ouverture effective de l'organe de coupure est détectée lorsque le nombre d'oscillations supérieures à la tension de référence est supérieur à un seuil prédéterminé et dans lequel la fermeture effective de l'organe de coupure (3) est détectée lorsque le nombre d'oscillations supérieures à la tension de référence est inférieur ou égal au seuil prédéterminé.

3. Procédé de commande d'une ouverture et/ou d'une fermeture d'un organe de coupure d'un compteur électrique (1) selon l'une des revendications précédentes, le procédé comportant l'étape, lorsqu'une ouverture est commandée, d'estimer le délai d'ouverture de l'organe de coupure (3) et d'anticiper la commande d'ouverture suivante de l'organe de coupure en fonction du délai d'ouverture et/ou l'étape, lorsqu'une fermeture est commandée, d'estimer le délai de fermeture de l'organe de coupure et d'anticiper la commande de fermeture suivante de l'organe de coupure en fonction du délai de fermeture.

4. Procédé de commande selon la revendication 3, dans lequel le délai d'ouverture est estimé et mis à jour à chaque commande d'ouverture pour anticiper la commande d'ouverture suivante et/ou le délai de fermeture est estimé et mis à jour à chaque commande de fermeture pour anticiper la commande de fermeture suivante.

5. Procédé de commande selon la revendication 3, comportant en outre une étape de calibration mise en oeuvre au moment de la fabrication du compteur électrique et au cours de laquelle le délai d'ouverture et/ou le délai de fermeture sont estimés et initialisés.

## Patentansprüche

1. Stromzähler, umfassend ein Unterbrechungsorgan (3), Steuermittel zum Steuern des Unterbrechungsorgans (3) und Schätzmittel zum Schätzen einer Öffnungsverzögerung zwischen einem Öffnungsbefehl und einer effektiven Öffnung des Unterbrechungsorgans (3) und/oder einer Schließverzögerung zwischen einem Schließbefehl und einer effektiven Schließung des Unterbrechungsorgans (3), wobei die Schätzmittel umfassen:
- einen induktiven Schwingkreis (6), der eine Spule (10) umfasst, die in Bezug auf das Unterbrechungsorgan ortsfest gegenüber einer Bahn eines beweglichen Kontakts (5) des Unterbrechungsorgans angeordnet ist;
- Sendemittel, die ausgebildet sind, um in den induktiven Kreis einen Spannungsimpuls auszusenden;
- Detektionsmittel, die ausgebildet sind, um ein gedämpftes oszillierendes Spannungssignal (So) am Ausgang des induktiven Kreises zu erfassen und es mit einer Referenzspannung zu vergleichen und um die Position des beweglichen Kontaktes (5) und folglich das effektive Öffnen oder das effektive Schließen des Unterbrechungsorgans abhängig von der Anzahl an Schwingungen zu erfassen, die größer als die Referenzspannung sind;
- Messmittel zum Messen der Zeit zwischen dem Öffnungsbefehl und dem Erfassen der effektiven Öffnung, um die Öffnungsverzögerung zu schätzen, und/oder zwischen dem Schließbefehl und dem Erfassen der effektiven Schließung, um die Schließverzögerung zu schätzen.

2. Stromzähler nach Anspruch 1, bei dem die effektive Öffnung des Unterbrechungsorgans erfasst wird, wenn die Anzahl an Schwingungen, die größer als die Referenzspannung sind, größer als ein vorbestimmter Schwellenwert ist, und bei dem die effektive Schließung des Unterbrechungsorgans (3) erfasst wird, wenn die Anzahl an Schwingungen, die größer als die Referenzspannung sind, kleiner oder gleich dem vorbestimmten Schwellenwert ist.

3. Steuerverfahren zum Steuern einer Öffnung und/oder einer Schließung eines Unterbrechungsorgans eines Stromzählers (1) nach einem der vorhergehenden Ansprüche, wobei das Verfahren, wenn eine Öffnung befohlen wird, den Schritt des Schätzens der Öffnungsverzögerung des Unterbrechungsorgans (3) und des Antizipierens des nächsten Öffnungsbefehls des Unterbrechungsorgans abhängig von der Öffnungsverzögerung und/oder, wenn eine Schließung befohlen wird, den Schritt des Schätzens der Schließverzögerung des Unterbrechungsorgans und des Antizipierens des nächsten Schließbefehls des Unterbrechungsorgans abhängig von der Schließverzögerung umfasst.

4. Steuerverfahren nach Anspruch 3, bei dem die Öffnungsverzögerung bei jedem Öffnungsbefehl geschätzt und aktualisiert wird, um den nächsten Öffnungsbefehl zu antizipieren und/oder die Schließverzögerung bei jedem Schließbefehl geschätzt und antizipiert wird, um den nächsten Schließbefehl zu antizipieren.

5. Steuerverfahren nach Anspruch 3, ferner umfassend einen Kalibrierungsschritt, der zum Zeitpunkt der Herstellung des Stromzählers durchgeführt wird und in dessen Verlauf die Öffnungsverzögerung und/oder die Schließverzögerung geschätzt und initialisiert werden.

## Claims

1. An electricity meter having a cutoff member (3), control means for controlling the cutoff member (3), and estimator means for estimating an opening delay between an open order and actual opening of the cutoff member (3), and/or a closing delay between a close order and actual closing of the cutoff member (3), the estimator means comprising:
• a resonant inductive circuit (6) comprising a coil (10) mounted stationary relative to the cutoff member and facing a path of a movable contact (5) of the cutoff member;
• send means arranged to send a voltage pulse into the inductive circuit;
• detector means arranged to detect a damped oscillating voltage signal (So) at the output from the inductive circuit and to compare it with a reference voltage, and to detect the position of the movable contact (5) and thus actual opening or actual closing of the cutoff member as a function of the number of oscillations above the reference voltage; and
• measurement means for measuring the time between the open order and detecting actual opening so as to estimate the opening delay, and/or between the close order and detecting actual closing so as to estimate the closing delay.

2. An electricity meter according to claim 1, wherein actual opening of the cutoff member is detected when the number of oscillations above the reference voltage is greater than a predetermined threshold, and wherein actual closing of the cutoff member (3) is detected when the number of oscillations above the reference voltage is less than or equal to the predetermined threshold.

3. A method of controlling opening and/or closing of a cutoff member of an electricity meter (1) according to either preceding claim, the method including a step, when an open order is issued, of estimating the opening delay of the cutoff member (3) and of issuing the following open order for the cutoff member early as a function of the opening delay, and/or a step, when issuing a close order, of estimating the closing delay of the cutoff member and of issuing the following close order for the cutoff member early as a function of the closing delay.

4. A control method according to claim 3, wherein the opening delay is estimated and updated on each open order in order to issue the following open order early, and/or the closing delay is estimated and updated on each close order in order to issue the following close order early.

5. A control method according to claim 3, further including a calibration step performed when the electricity meter is manufactured and during which the opening delay and/or the closing delay are estimated and initialized.
